(19) Europäisches Patentamt
European Patent Office
Office européen des brevets

(11) EP 4 199 071 A1

(12) EUROPEAN PATENT APPLICATION

(43) Date of publication:
21.06.2023 Bulletin 2023/25

(21) Application number: 21214621.1

(22) Date of filing: 15.12.2021

(51) International Patent Classification (IPC):
H01L 23/36 (2006.01)      H01L 21/60 (2006.01)
H01L 23/66 (2006.01)      H01L 25/10 (2006.01)

(52) Cooperative Patent Classification (CPC):
(C-Sets available)
H01L 24/19; H01L 21/568; H01L 21/6835;
H01L 21/6836; H01L 23/36; H01L 23/473;
H01L 23/66; H01L 24/20; H01L 24/08; H01L 24/27;
H01L 24/29; H01L 24/32; H01L 24/73; H01L 24/80;
H01L 24/83;                                    (Cont.)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: IHP GmbH - Innovations for High
Performance
Microelectronics / Leibniz-Institut für
innovative Mikroelektronik
15236 Frankfurt (Oder) (DE)

(72) Inventors:
• Wietstruck, Matthias
  15236 Frankfurt (Oder) (DE)
• Kahmen, Gerhard
  15236 Frankfurt (Oder) (DE)
• Krüger, Patrick
  15236 Frankfurt (Oder) (DE)
• Voß, Thomas
  15236 Frankfurt (Oder) (DE)
• Stocchi, Matteo
  15236 Frankfurt (Oder) (DE)

(74) Representative: Eisenführ Speiser
Patentanwälte Rechtsanwälte PartGmbB
Stralauer Platz 34
10243 Berlin (DE)

(54) **FAN-OUT WAFER-LEVEL PACKAGE**

(57)     Fan-out wafer-level package (1000) comprising at least one integrated circuit (100), an internal heat spreader (200) thermally connected to the integrated circuit either directly or via an interface layer (210) having a thickness in $\mu$m- or sub-$\mu$m range preferably in the range of 20 nm to 1 mm, wherein the internal heat spreader is embedded in the fan-out wafer-level package.

Fig. 2A

Fig. 2B

(52) Cooperative Patent Classification (CPC): (Cont.)
H01L 24/92; H01L 25/105; H01L 2221/68327;
H01L 2221/68345; H01L 2221/6835;
H01L 2221/68354; H01L 2221/68359;
H01L 2223/6677; H01L 2224/04105;
H01L 2224/08145; H01L 2224/08225;
H01L 2224/08245; H01L 2224/12105;
H01L 2224/27002; H01L 2224/29124;
H01L 2224/29147; H01L 2224/32145;
H01L 2224/32225; H01L 2224/32245;
H01L 2224/73251; H01L 2224/73267;
H01L 2224/80132; H01L 2224/83132;
H01L 2224/83191; H01L 2224/83192;
H01L 2224/83193; H01L 2224/9222;
H01L 2224/92244; H01L 2224/97;
H01L 2225/1035; H01L 2225/1041;
H01L 2225/1058; H01L 2225/1094;
H01L 2924/10253; H01L 2924/10271;
H01L 2924/14; H01L 2924/19041;
H01L 2924/19042

C-Sets
H01L 2224/73251, H01L 2224/08, H01L 2224/19;
H01L 2224/73251, H01L 2224/08, H01L 2224/20;
H01L 2224/9222, H01L 2224/80, H01L 2224/19;
H01L 2224/97, H01L 2224/80;
H01L 2224/97, H01L 2224/83

## Description

The invention relates to a fan-out wafer-level package, a module comprising a fan-out wafer-level package and a method for fabricating a fan-out wafer-level package.

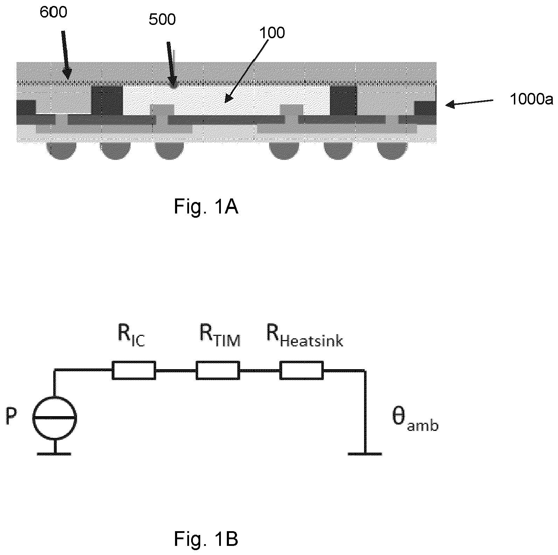

A generic example of a fan-out wafer-level package (FOWLP) is shown in Figure 1. Nowadays different FOWLP technologies are developed which differs in the way how these packages are realized. For heat management, the backside of such a FOWLP, which is typically a mold material with low thermal conductivity, is removed. Based on a thermal interface material (TIM), a heat spreader and/or heatsink is applied on top to remove the heat from the integrated circuit over the backside of the silicon chip (Figure 1A). The equivalent circuit of the thermal resistance is also shown in Figure 1B. In this configuration, the thermal resistance of the TIM ($R_{TIM}$) with values of $K*mm^2/W$ is typically dominating the overall thermal resistance as long as the silicon thickness is thick enough to ensure a thermal spreading from the heat source to the backside of the IC (typically thickness of hundreds of $\mu m$). Such high thermal resistance is unfavourable.

It is an object of the invention to create an alternative and improved FOWLP concept for fanning out electrical signals but enabling at the same time significantly lower thermal resistance compared to conventional FOWLP techniques.

This object is achieved by a fan-out wafer-level package comprising

- at least one integrated circuit,

- an internal heat spreader thermally connected to the integrated circuit

either directly or via an interface layer having a thickness in $\mu m$- or sub-$\mu m$ range preferably in the range of 20 nm to 1 mm,
wherein the internal heat spreader is embedded in the fan-out wafer-level package.

The invention is based on the recognition that an integrated heat spreader inside the package helps to enlarge the area/volume for heat dissipation before any additional heat management is applied resulting in an improved thermal resistance of the package. As a result between the initial die and the heat spreader, no TIM material with typically low/medium thermal conductivity and thicknesses with typically tens of $\mu m$ TIM thickness is required. Furthermore the invention uses a direct connection between the initial die with the integrated circuit and the heat spreader or just a thin interface layer in the $\mu m$ or sub-$\mu m$ range with good thermal conductivity to reduce the thermal resistance. Based on this technique the thermal resistance of the initial die to the first heat spreader can be reduced from $K*mm^2/W$ range in know FOWLP to $mK*mm^2/W$ with the invention. At the same time, the interface layer is also used for the mechanical connection of the initial die with the integrated circuit and the heat spreader which ensures a very good reliability. Compared to standard heat spreader approaches, the internal heat spreader does not need to have a high quality substrate for radio-frequency (RF) applications (e.g. HR substrate). It can be realized with low cost substrates because the redistribution layers (RDL) can be far away from the internal heat spreader thus no effect will be initiated by a substrate, which is not high quality, especially for RF applications.

Based on the concept of the invention, an electrically conductive or non-conductive connection between IC and the package or a further heatsink can be realized (based on the internal heat spreader and if applicable the interface layer) with low thermal resistance, whereas for standard FOWLP especially the non-conductive interface typically creates a significant high thermal resistance because of the low thermal conductivity of insulating thermal interface materials.

Beside the availability for fanning-out from fine-pitch integrated circuits to PCBs with a significant higher pitch, a significant reduction of the thermal resistance of the overall package is achieved by the fan-out wafer-level package according to the invention because the internal heat spreader acts also as heat spreader inside the package. The combination of the ultra-thin interface between the integrated and the embedded internal heat spreader with a thermal resistivity in the range of $mK*mm^2/W$ together with a spreading of the heat itself inside the package allows to realize ultra-low thermal resistances. Especially for integrated circuit substrates with low thermal conductivity (e.g. GaAs), this package can also provide a low thermal resistance because the integrated circuit itself can be extremely thin, which is not possible for standard FOWLP due to the limited mechanical stability of those substrate-less approaches. The thin substrate is connected to the package-embedded internal heat spreader and comparable low thermal resistance can be achieved.

In contrast to known TIM layer and external heat sinks the internal head spreader (and if applicable the interface layer) is embedded in the FOWL package during fabrication of the fan-out wafer-level package and not via additional assembling steps after fabrication of the fan-out wafer-level package.

In preferred embodiment there is a large difference between a die size of the integrated circuit and the FOWL package size, for example a difference in the area factor of the die having half or less the size of the FOWL package is preferred. In such an embodiment the improvement achieved with the invention is remarkably strong. The invention furthermore shows strong improvement for small die sizes in general. The invention is furthermore beneficially used with semiconductor technologies with low thermal conductivity (e.g. GaAs) due to the minimum thickness of the integrated circuits.

The concept of the invention is applicable to different substrate types, for example Si, SiGe but also CMOS or III-V on Si.

The heat spreader may be either placed between fan-out areas of the fan-out wafer-level package as the integrated circuit or on top of the integrated circuit and at least parts of fan-out areas of the fan-out wafer level.

A preferred thickness of the interface layer is in the range of 20 nm to 30 $\mu$m. An even more preferred thickness range is 30-200 nm, more preferred 50 to 100 nm. Lower thicknesses are preferred to keep the layer as thin as possible for thermal reasons. But especially if the interface layer should be electrically isolating it needs to have a certain thickness to provide a high enough dielectric breakdown voltage which depends on the specific application requirements. Especially in embodiments, where the heat spreader is placed between fan-out areas of the fan-out wafer-level package higher thicknesses of the interface layer up to 1 mm are possible. Such high thicknesses can be helpful to compensate thicknesses between the integrated circuit and the fan-out-area. The interface layer may be realized in a multi-layer approach dependent on the fabrication process. For example a first layer of the interface layer may be realized on a die comprising the integrated circuit and a second layer of the interface layer may be realized on the internal heat spreader.

It is preferred that the internal head spreader has a thermal resistivity in the range of mK*mm$^2$/W. The internal heat spreader may comprise Si or a metal.

The interface layer may comprise different electrically/thermally conductive or non-conductive layers (e. g. SiO2, Al2O3, Al or Cu). For heat management purposes, a material suitable for permanent bonding together with good thermal conductivity is preferable.

In an embodiment the fan-out wafer-level package comprises at least two integrated circuits, wherein the internal heat spreader is thermally connected to the at least two integrated circuits. This embodiment may thus act as a multi-chip module by placing more than one integrated circuit inside a package. The different integrated circuits be either passive or active and may be based on the same or another technology (e.g. SiGe, CMOS, III-V on Si).

In a further embodiment the internal heat spreader comprises additional heat sink structures. Thus the thermal management can be realized without any additional TIM and/or external heat spreader because the package already includes the overall thermal management components. Although the combined heat spreader/heatsink based on the internal heat spreader might be less performant compared to standalone components, the reduced thermal path with a minimum number of thermal interfaces due to the eliminated TIM and external heat spreader/heatsink can provide very low thermal resistance with a significant lower volume. The additional heat sink structures may be integrated cooling ribs or micro-channels of a microfluidic cooling systems.

Preferably the fan-out wafer-level package additionally comprises a redistribution layer, wherein the redistribution layer is a single or multi-layer redistribution layer.

Preferably the fan-out wafer-level package additionally comprises interconnections electrically connected to the at least one integrated circuit, preferably pillars or solder balls, preferably comprising Cu.

In an embodiment the fan-out wafer-level package comprises an additional redistribution layer on a backside of the fan-out wafer-level package and at least one trough-substrate via electrically connecting the additional redistribution layer to a front of the fan-out wafer-level package, preferably to the at least one integrated circuit. The backside redistribution layer may be used e. g. for the implementation of high-Q passives using thick metals or allows for the assembly of surface-mounted devices (SMD)-like components.

In this embodiment the fan-out wafer-level may additionally comprise at least one area with an active or passive functionality. Examples for passive functionalities are e.g. high-Q inductors, capacitors or antennas. Examples of active functionalities are active devices e. g. varactors, diodes, transistors, etc. But it is also possible to add different types of sensors e.g. photo-detectors or chemical sensors. This may be realized with or without through silicon vias (TSVs) dependent on the type of device. Such functionalities could be implemented e.g. with standard FEOL or BEOL fabrication steps or RDL fabrication steps. In summary the fan-out wafer-level package gives the possibility to add other components not in a monolithic approach (within the CMOS/BiCMOS) which is not preferred but in a heterogeneous approach which is rather flexible for any type of device integration.

The fan-out wafer-level may have additionally an external thermal interface thermally connecting the fan-out wafer-level package with an external heat sink. It is then preferred that the internal heat spreader is arranged between the interface layer and the external thermal interface.

According to a second aspect the invention relates to a module comprising a fan-out wafer-level package according to the first aspect of the invention and at least one additional functional element either on top or on bottom of the fan-out wafer level package. The at least one additional functional element may be an active or passive element. Examples for passive elements are e. g. high-Q inductors, capacitors, lenses or antennas. Examples of active elements are active devices e.g. varactors, diodes, transistors, etc. Furthermore different types of sensors e.g. photo-detectors or chemical sensors may be used as functional element. Thus the invention also allows for example for 3D integration, e.g. 3D stacking.

In an embodiment the module comprises a fan-out wafer-level package with a redistribution layer and at least one embedded antenna realized within the redistribution layer or as aperture-type antenna, which is built to be fed with a feeding structure inside the redistribution together with an additional antenna structure within a bonding interface area of the fan-out wafer-level package. In a further embodiment the module additionally comprises a lens, preferably a Si lens or plastic lens. The lens is preferably realized in a hemispherical or meta-material based lens configuration. The additional lens may be placed directly on top of the package backside. The meta-material based lens may be a hole-type or pillar-type lens. Beside the functionality for the antenna and radiation the additional lens may directly act also as heatsinkthus no additional heatsink is required. In this case metamaterial based antennas with etched pillars are advantageous because the area for heat transfer based on natural/forced convection is strongly increased.

According to a third aspect the invention relates to a method for fabricating a fan-out wafer-level package comprising the steps:

- providing a semiconductor wafer with at least one integrated circuit;

- optionally thinning down the semiconductor wafer to a desired thickness from a backside of the semiconductor wafer;

- optionally subsequent polishing the backside of the semiconductor wafer and/or applying an interface layer on the backside of the semiconductor wafer;

- singulating the semiconductor wafer into at least one die comprising the at least one integrated circuit;

- providing an internal heat spreader substrate comprising a heat spreader material;

- optionally patterning a surface of the internal heat spreader substrate or an additional permanent bonding layer deposited on the surface of the internal heat spreader substrate;

- depositing a dielectric layer with at least one cavity on a surface of the internal heat spreader substrate, wherein the at least one die fits into the at least one cavity of the dielectric layer;

- placing the at least one die in the at least one cavity;

- bonding the at least one die to the internal heat spreader substrate.

In an embodiment the method further comprises after singulating the wafer the following steps:

- optionally placing the at least one die on a handling wafer;

- thinning down the at least one die to a desired thickness;

- removing the at least one die from the handling wafer.

In an embodiment the method further comprises depositing an interface layer having a thickness in $\mu$m- or sub-$\mu$m range, preferably in the range of 20 nm to 30 $\mu$m, at a bottom of the at least one cavity before placing the at least one die in the at least one cavity or depositing the interface layer on the thinned semiconductor wafer.

In a further embodiment of the method depositing the dielectric layer with at least one cavity comprises

- depositing a dielectric layer on the surface of the internal heat spreader substrate and subsequent patterning the dielectric layer or

- placing a dielectric wafer with at least one fully prepared cavity on the surface of the internal heat spreader substrate or

- placing a dielectric wafer with at least one blind cavity on the surface of the internal heat spreader substrate and thinning down the wafer to fully realize the at least one cavity.

The method may further comprise the steps of applying a redistribution layer on a top the fan-out wafer-level package electrically connecting the at least one integrated circuit and applying interconnections electrically connecting the redistribution layer. The method may also comprise the step of singulating at least one individual fan-out wafer-level package.

Providing the semiconductor wafer may comprise fabricating the semiconductor wafer (e.g. CMOS/BiCMOS, III-V on silicon, Si or SiGe) with its front-end-of-line (FEOL) and/or backend-of-line (BEOL) in a standard fabrication approach.

Thinning the semiconductor wafer may comprise a carrier wafer bonding process. In an embodiment this takes place with a temporary wafer bonding process which is typically done based on adhesives which are placed in between a carrier wafer and the semiconductor wafer.

Removing the at least one die from the handling wafer may comprise debonding by a debonding techniques, preferably thermal or mechanical debonding techniques.

Singulating the semiconductor wafer may be realized by different method, e.g. by blade dicing, laser dicing or any other technique to define the final dimensions of the integrated circuit. Alternatively a Dicing-before-Grinding (DBG) approach where trenches are realized from a front side of the wafer and the individual dies are singulated by a backside thinning may be used.

Bonding the at least one die to the internal heat spreader substrate may comprise an annealing step.

In an embodiment of the method after placing the at least one die in the at least one cavity a planarization step takes place. This has the advantage to compensate local or global topography variations between the dielectric layer and the placed at least one die. Planarization may be achieved e.g. by an additional dielectric layer deposition with or without a subsequent chemical-mechanical polishing (CMP) or coating of a polymer layer on top.

The single or multi-layer redistribution layer may be added by a metallization technique e.g. by standard BEOL technologies, semi-additive techniques or subtractive RDL fabrication.

Singulating the at least one individual fan-out wafer-level package is realized + e.g. by blade dicing, laser dicing or any other technique to define the final package dimensions.

For further advantages, design variants and design details of the further aspects and the possible developments thereof, reference is also made to the above description relating to the corresponding features and developments of the fan-out wafer-level package.

Preferred embodiments of the invention will be discussed by way of example on the basis of the appended figures, in which:

Fig. 1 shows a cross section of a fan-out wafer-level package according to the state of the art with thermal interface material and heatsink for thermal management (Fig. 1A) and equivalent circuit of thermal resistance of a standard eWLB package (Fig. 1B);

Fig. 2 shows a cross section of an embodiment of a fan-out wafer-level package according to the invention (Fig. 2A) and an equivalent circuit of thermal resistance of this FOWLP (Fig. 2B)

Fig. 3A, 3B, 3C show an embodiment of a method for fabricating a fan-out wafer-level package according to the third aspect of the invention and the respective stages of the fan-out wafer-level package during fabrication;

Fig. 4 shows alternative method steps of a method for fabricating a fan-out wafer-level package according to the third aspect of the invention;

Fig. 5 shows a cross section of a further embodiment of a fan-out wafer-level package according to the invention;

Fig. 6 shows a cross section of a further embodiment of a fan-out wafer-level package according to the invention;

Fig. 7 shows a cross section of a further embodiment of a fan-out wafer-level package according to the invention;

Fig. 8 shows a cross section of a further embodiment of a fan-out wafer-level package according to the invention;

Fig. 9 shows a cross section of an embodiment of a module according to the second aspect of the invention;

Fig. 10 shows a cross section of a further embodiment of a module according to the second aspect of the invention;

Fig. 11 shows a cross section of a further embodiment of a fan-out wafer-level package according to the invention.

In the following description of the embodiments similar reference signs belong to similar elements.

Fig. 1 shows a cross section of a fan-out wafer-level package according to the state of the art with thermal interface material and heatsink for thermal management (Fig. 1A) and equivalent circuit of thermal resistance of a standard embedded wafer level ball grid array (eWLB) package (Fig. 1B) and is already discussed in the introduction. The shown FOWLP 1000a has a heat spreader 600 applied on top of the FOWLP 1000a based on a thermal interface material 500 to remove the heat from the integrated circuit 100 over the backside of the silicon chip. The equivalent circuit of the thermal resistance is also shown in Figure 1B.

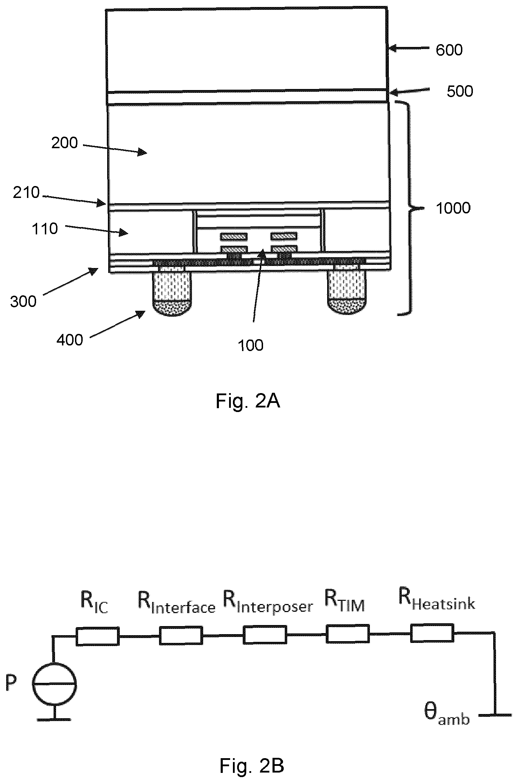

Fig. 2 shows a cross section of an embodiment of a fan-out wafer-level package 1000 according to the invention (Fig. 2A) and an equivalent circuit of thermal resistance of this FOWLP (Fig. 2B). The shown embodiment of a fan-out wafer-level package 1000 comprises one integrated circuit 100 between the fan-out. An internal heat spreader 200 is thermally connected to the integrated circuit 100 via an interface layer 210. In the shown example the interface layer 210 has a preferred thickness of 50 $\mu$m. The internal heat spreader 200 is embedded in the fan-out wafer-level package 1000. The integrated circuit 100 is arranged between fanning-out areas 110. The fanning-out is further realized with an redistribution layer RDL 300. The fan-out wafer-level package 1000 further comprises interconnections 400, herein as Cu pillars. This fan-out wafer-level package 1000 is connected using a thermal interface material 500 and an external heat sink 600 for heat management. The equivalent circuit of the thermal resistance is shown in Fig. 2B. Compared to the standard FOWLP technologies, the internal heat spreader 200 as a first heat spreader is already included within the FOWLP ($R_{Internal\ heat\ spreader}$) and connected to the IC using a sub-$\mu$m/nm-range interface material ($R_{interface}$) and a comparable thin IC. This combination allows to realize a low thermal resistance between the IC and the package-embedded heat spreader together with a heat spreading before the thermal interface material.

The package embedded internal heat spreader ensures to provide a large area for the heat transfer over the TIM material. Based on the following equation, the $R_{TIM}$ can be strongly reduced because the complete package area $A_{package}$ is used for heat transfer compared to the small area of the IC $A_{IC}$, which is used for an embedded wafer level ball grid array FOWLP.

$$R_{TIM} = \frac{1}{\lambda_{TIM}} * \frac{t_{TIM}}{A_{package}}$$

Thus an electrically conductive or non-conductive connection between IC 100 and the heat spreader 200 is realized (based on the interface layer material) with low thermal resistance, whereas for standard FOWLP especially the non-conductive interface typically creates a significant high thermal resistance because of the low thermal conductivity of insulating thermal interface materials.

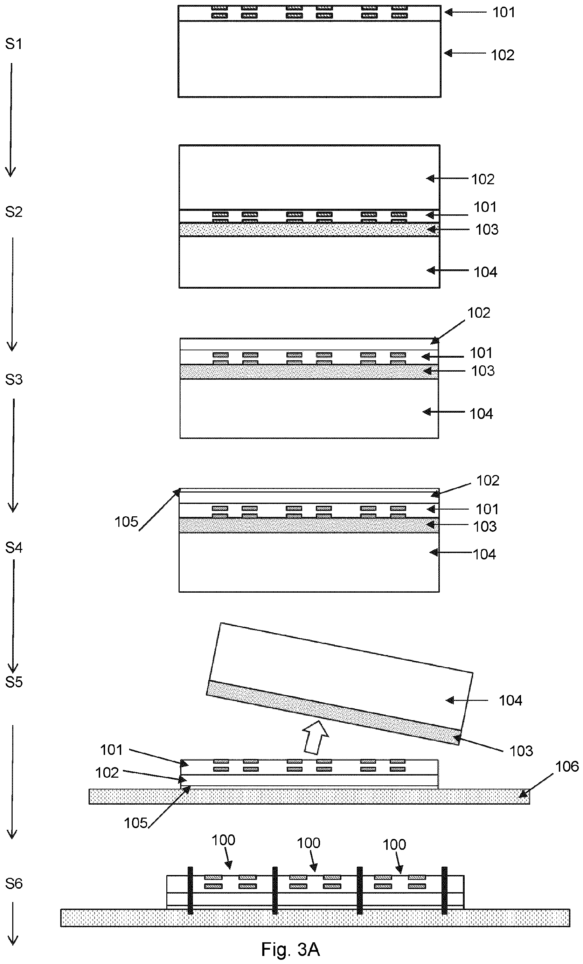

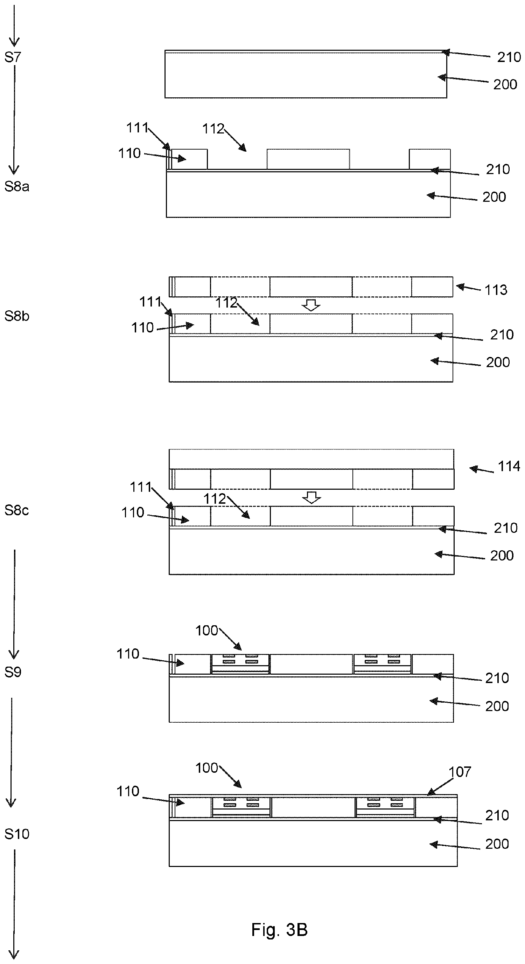

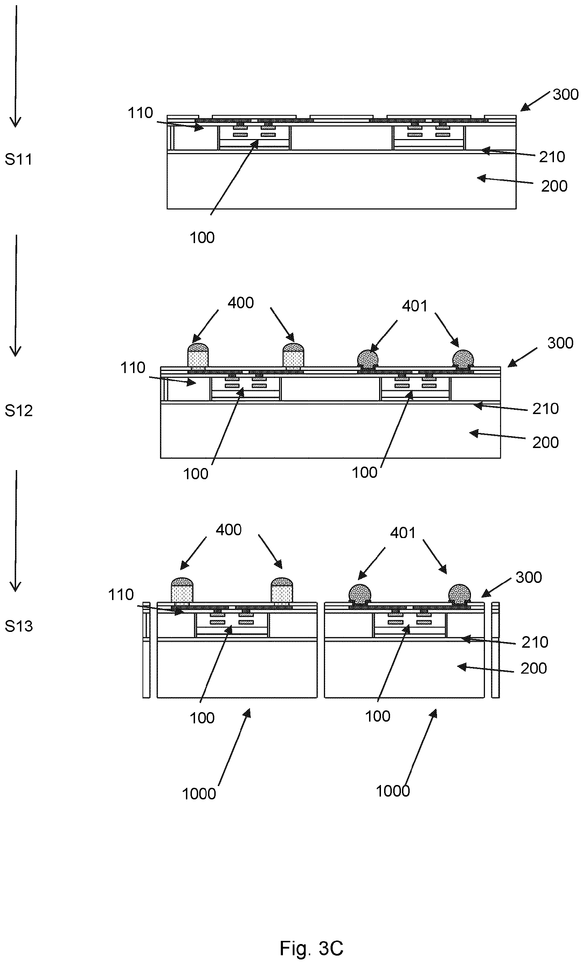

Fig. 3A, 3B, 3C show an embodiment of a method for fabricating a fan-out wafer-level package according to the third aspect of the invention and the respective stages of the fan-out wafer-level package during fabrication;

A semiconductor wafer 102 (e.g. CMOS/BiCMOS or III-V on silicon) is fabricated with its front-end-of-line (FEOL) and/or backend-of-line (BEOL) in a standard fabrication approach in step S1 resulting in the semiconductor wafer 102 with a device layer 101. Dependent on the final target thickness of the actual wafer or integrated circuits, a thinning of a carrier wafer handling process might be applied. This can be realized e.g. with a temporary wafer bonding process which is typically done based on an adhesive layer 103 which is placed in between the carrier wafer 104 and the semiconductor wafer 102 with the device layer 101 (S2). The carrier wafer 104 will ensure, that the semiconductor wafer 102 can be thinned down (e.g. down to a thickness <<150 $\mu$m) in step S3 and further processed on the thinned surface. For larger target thicknesses, a carrier wafer handling might not be required and following process steps of polishing and/or deposition of permanent bonding layers can be directly applied. The semiconductor wafer 102 is thinned down to the desired thickness in step S3. A subsequent polishing based on chemical, mechanical or chemical-mechanical techniques is then applied to achieve a low surface roughness in step S4. Based on the later applied bonding technique, either the polished surface, herein preferred a silicon surface, can be directly used or an additional layer can be applied. In the following the process is shown and described for the case of an additional bonding layer. The bonding layer 105 is deposited on the backside of the thinned semiconductor wafer 102 which will act as bonding interface layer for the later permanent bonding process in S4. Different electrically/thermally conductive or non-conductive materials may be used in the bonding layer 105 (e.g. SiO2, Al2O3, Al or Cu). For heat management purposes, a material suitable for permanent bonding together with good thermal conductivity is preferable. The permanent bonding layer may serve as interface layer. In this case the bonding layer 105 has a thickness in $\mu$m- or sub-$\mu$m range preferably in the range of 20 nm to 30 $\mu$m. The whole wafer is then placed on a tape 106 and the carrier wafer 104 is debonded by a debonding techniques (e.g. thermal or mechanical debonding) in step S5. In step S6 the semiconductor wafer and its device layer are singulated into dies comprising the integrated circuit 100 e.g. by blade dicing, laser dicing or any other technique. The singulation can be also done in a so-called Dicing-before-Grinding (DBG) approach where trenches are realized from front side of the wafer and the individual dies with the integrated circuits are singulated by a backside thinning.

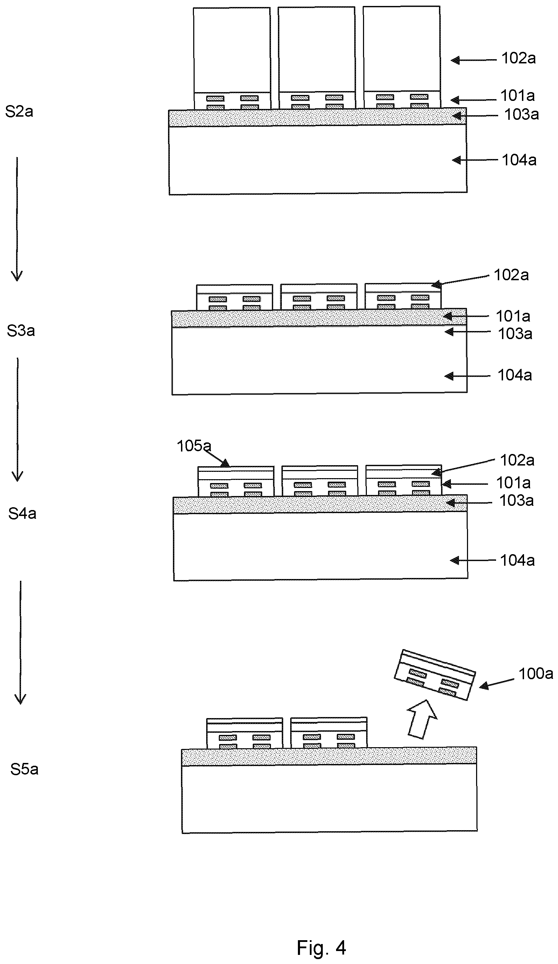

In step S7 in Fig. 4B an internal heat spreader substrate 200 comprising a heat spreader material is provided. A material with high thermal conductivity is preferable (e.g. Si or metal) as heat spreader material. Dependent on the permanent bonding process, either a surface of the heat spreader substrate 200 itself or a permanent bonding layer 210 can be deposited (e.g. SiO2, Al2O3, Al or Cu) and/or further patterned. In the shown embodiment a bonding layer 210 is deposited on heat spreader substrate 200. As bonding layer 105 bonding layer 210 may serve as interface layer. In some embodiments of the fan-out wafer-level package either one of the bonding layers 105 and 210 or both bonding layers together can form the interface layer.

In the following a heat spreader substrate with bonding layer 210 is used. A dielectric layer 110 is added on top of the bonding layer 210 in step S8a. This can be realized e.g. by SiO2 or any other BEOL dielectric layer, spin-coated polymer, dry-film polymer. The dielectric layer is patterned in a way that the individual dies can fit into cavities 112. As an alternative, a wafer 113, 114 (e.g. silicon, glass) with realized blind (step S8b) or full cavities (step S8c) can be also combined to create the dielectric layer with open cavities. The final cavity height should be the same like the total thickness of the integrated circuits. A specific alignment mark 111 is preferably used either in the dielectric, the bonding layer or the heat spreader substrate below to enable accurate die placement/bonding in the next step.

Dependent on the material selection and functionality, different variants and combinations of the bonding layer and the dielectric layer can be realized. For example the bonding layer can be realized only within the cavities or within the cavities and under the dielectric layer. It is also possible to use an internal heat spreader without any bonding layer using directly the internal heat spreader surface for bonding to either an interface layer on the integrated circuit or directly to the integrated circuit.

The following further fabrication is shown for the case of interface layers on both sides, thus with bonding layers 105 and 210, but can also be realized with the different aforementioned configurations. The prepared integrated circuits 100 in the respective dies are placed within the cavities preferably with ideal lateral alignment accuracy in the μm-range or below in step S9. Dependent on the applied material and permanent bonding approach, an annealing step may be applied to enable simultaneous bonding of all integrated circuits 100 which leads to a mechanical connection between the dies and the internal heat spreader 200.

A planarization step may optionally be applied to compensate local or global topography variations between the dielectric layer and the placed integrated circuits. The planarization may be achieved e.g. by an additional dielectric layer deposition with or without a subsequent chemical-mechanical polishing (CMP) or coating of a polymer layer on top. In the shown embodiment a dielectric layer 107 is deposited in step S10. For routing purposes, a multi-layer redistribution layer (RDL) is added in the shown embodiment in S11. In other embodiment the redistribution layer may be a single layer. Addition of the RDL can be achieved by different metallization techniques e.g. by standard BEOL technologies, semi-additive techniques or subtractive RDL fabrication. For a subsequent next-level of integration, interconnections e.g. based on Cu-pillars 400 or solder balls 401 are applied on top of the RDL in step S12.

Finally the substrate is singulated e.g. by blade dicing, laser dicing or any other technique to define the final package dimensions in step S13 resulting in two fan-out wafer-level packages 1000. Those packages can be directly assembled on the next substrate e.g. a printed circuit board (PCB).

In an alternative embodiment the aforementioned process can be also done using a die-to-wafer level approach for preparation of the dies. Fig. 4 shows these alternative method steps of a method for fabricating a fan-out wafer-level package according to the third aspect of the invention. Singulated individual dies comprising a device layer 101a and a semiconductor layer 102a are placed on a carrier wafer 104a with an adhesive layer 103a in step S2a. The individual dies are thinned down to the target thickness in step S3a and a polishing step may be applied to ensure a low surface roughness. Dependent on the permanent bonding process, a bonding layer 105a may be deposited in step S4a. Subsequently the thinned dies 100a can be removed/debonded from the carrier wafer by an assembly step (e.g. pick & place or die-bonding process) in step S5a To ensure a minimum mechanical stress to the thin dies, a debonding of the dies under a small tilt is preferable compared to a parallel debonding process.

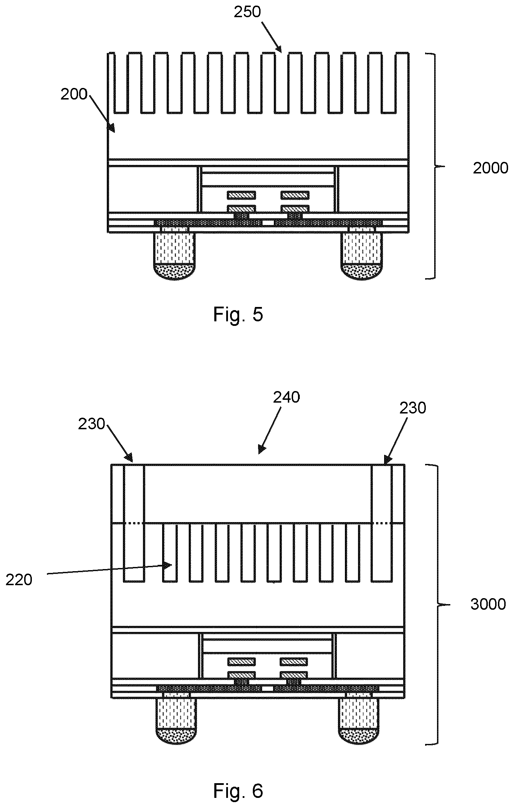

Fig. 5 shows a cross section of a further embodiment of a fan-out wafer-level package 2000 according to the invention. In this embodiment in the internal heat spreader 200 a heatsink is directly implemented by structuring the internal heat spreader 200 itself with cooling ribs 250. With this embodiment the thermal management can be realized easily without any additional TIM and/or external heat spreader because the fan-out wafer level package already includes the overall thermal management components. Although the combined heat spreader/heatsink based on the internal heat spreader might be less performant compared to standalone components, the reduced thermal path with a minimum number of thermal interfaces due to the eliminated TIM and external heat spreader/heatsink can provide very low thermal resistance with a significant lower volume.

Fig. 6 shows a cross section of a further embodiment of a fan-out wafer-level package 3000 according to the invention. Herein a similar concept to one in Fig. 5 is applied to directly embed a microfluidic cooling inside the proposed FOWLP. The internal heat spreader 200 in this embodiment includes micro-channels 220, which can be connected using a flexible microfluidic interface 240 with in- and outlets 230 .

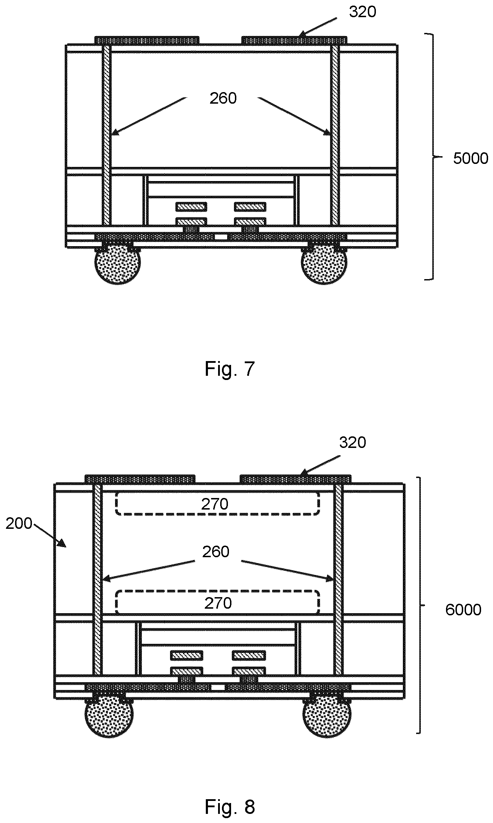

Fig. 7 shows a cross section of a further embodiment of a fan-out wafer-level package 5000 according to the invention. In the shown embodiment an additional redistribution layer 320 is place on the backside of the fan-out wafer-level package 5000, which is built-up similar to the one shown in Fig. 2 but with additional through-substrate vias (TSV) 260 to realize a connection from front to backside. The backside redistribution layer 320 can be used e.g. for the implementation of high-Q passives using thick metals or even allows for the assembly of surface-mounted devices (SMD)-like components.

Fig. 8 shows a cross section of a further embodiment of a fan-out wafer-level package 6000 according to the invention. Fan-out wafer-level package 6000 is similar to fan-out wafer-level package 5000 of Fig. 7. Herein the internal heat spreader 200 comprises additional active or passive functionalities 270. Thus the internal heat spreader can be considered as functionalized heat sink with active/passive functionality.

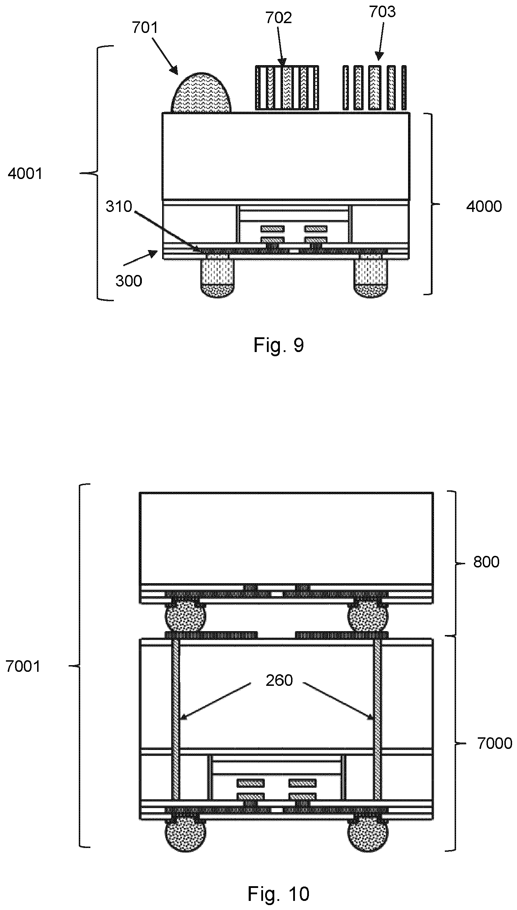

Fig. 9 shows a cross section of an embodiment of a module 4001 according to the second aspect of the invention. The module 4001 comprises a fan-out wafer-level package 4000, which is built-up similar to the fan-out-wafer-level package 1000 of Fig. 2 and an embedded antenna 310 within the redistribution layer 300 on bottom of the fan-out wafer level package 4000. As alternative an aperture-type antenna may be used, which can be feed with a structure inside the redistribution layer together with an additional antenna structure within the bonding interface area. In the shown embodiment additional lenses 701, 702, 703 are placed directly on top of the package backside. Herein three types of lenses are shown, of which each may be used alone or in combination. Lens 701 is a hemispherical lens. Lenses 702 and 703 or meta-material based lenses, wherein lens 703 is a pillar-type meta-material lens and lens 702 is a hole-type meta-material lens. Beside the functionality for the antenna and radiation the lens can directly act also as heatsink thus no additional heatsink is required. In this case meta-material based antennas with etched pillars are advantageous because the area for heat transfer based on natural/forced convection is strongly increased compared to hemispherical lenses.

Fig. 10 shows a cross section of a further embodiment of a module 7001 according to the second aspect of the invention. Fan-out wafer-level package 7000 is similar built to fan-out wafer-level package 5000 of Fig. 7. Based on the additional backside redistribution layer an additional functional element 800 is assembled on top of the fan-out wafer-level package 7000. Thus this fan-out wafer-level package is directly used for 3D integration, here for 3D stacking.

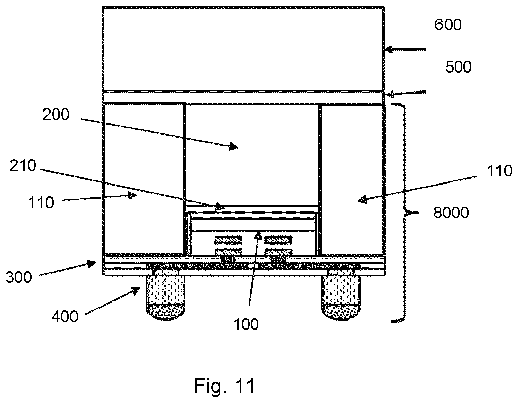

Fig. 11 shows a cross section of a further embodiment of a fan-out wafer-level package 8000 according to the invention. Fan-out wafer-level package 8000 is similar built to fan-out wafer-level package 1000 of Fig. 2. In contrast to fan-out wafer-level package 1000 in fan-out wafer-level package 8000 the internal heat spreader 200 and the interface layer 210 are arranged between the fan-out areas 110.

Reference signs

| | |
|---|---|
| 100 | integrated circuit |
| 1000 | fan-out wafer-level package |
| 1000a | fan-out wafer-level package |
| 101 | device layer |
| 102 | semiconductor wafer |
| 103 | adhesive layer |
| 104 | carrier wafer |
| 105 | bonding layer |
| 106 | tape |
| 107 | dielectric layer |
| 110 | fanning-out area |
| 111 | alignment mark |
| 112 | cavity |
| 113 | wafer |
| 114 | wafer |
| 200 | internal heat spreader |
| 210 | interface layer |
| 300 | redistribution layer |
| 400 | interconnections |
| 500 | thermal interface material |
| 600 | heat spreader |
| 100a | thinned die |
| 101a | device layer |
| 102a | semiconductor layer |
| 103a | adhesive layer |
| 104a | carrier wafer |
| 105a | bonding layer |
| 220 | micro-channels |
| 230 | outlets |
| 240 | microfluidic interface |
| 250 | cooling ribs |
| 260 | through-substrate via |
| 270 | passive functionality |

| | |
|---|---|
| 310 | embedded antenna |
| 320 | additional redistribution layer |
| 401 | balls |
| 701 | lens |
| 702 | lens |
| 703 | lens |
| 800 | additional functional element |
| 2000 | fan-out wafer-level package |
| 3000 | fan-out wafer-level package |
| 4000 | fan-out wafer-level package |
| 4001 | module |
| 5000 | fan-out wafer-level package |
| 6000 | fan-out wafer-level package |
| 7000 | fan-out wafer-level package |
| 7001 | module |
| 8000 | fan-out wafer-level package |

**Claims**

1. Fan-out wafer-level package comprising

   - at least one integrated circuit,
   - an internal heat spreader thermally connected to the integrated circuit

   either directly or via an interface layer having a thickness in $\mu$m- or sub-$\mu$m range preferably in the range of 20 nm to 1 mm, wherein the internal heat spreader is embedded in the fan-out wafer-level package.

2. Fan-out wafer-level package according to claim 1, wherein the internal head spreader has a thermal resistivity in the range of mK*mm$^2$/W.

3. Fan-out wafer-level package according to any of the preceding claims, wherein the internal heat spreader comprises Si or a metal.

4. Fan-out wafer-level package according to any of the preceding claims comprising at least two integrated circuits, wherein the internal heat spreader is thermally connected to the at least two integrated circuits.

5. Fan-out wafer-level package according to any of the preceding claims, wherein the internal heat spreader comprises additional heat sink structures.

6. Fan-out wafer-level package according to claim 5, wherein the additional heat sink structures are integrated cooling ribs or wherein the additional heat sink structures are micro-channels of a microfluidic cooling systems.

7. Fan-out wafer-level package according to any of the preceding claims comprising an additional redistribution layer on a backside of the fan-out wafer-level package and at least one trough-substrate via electrically connecting the additional redistribution layer to a front of the fan-out wafer-level package, preferably to the at least one integrated circuit.

8. Fan-out wafer-level package according to claim 7 comprising at least one area with an active or passive functionality.

9. Module comprising a fan-out wafer-level package according to any of the preceding claims and at least one additional functional element either on top or on bottom of the fan-out wafer level package.

10. Module according to claim 9 comprising a redistribution layer and at least one embedded antenna as functional element realized within the redistribution layer or as aperture-type antenna, which is built to be fed with a feeding structure inside the redistribution layer together with an additional antenna structure within a bonding interface area of the fan-out wafer-level package, preferably the module further comprising a lens.

11. Method for fabricating a fan-out wafer-level package comprising the steps:

- providing a semiconductor wafer with at least one integrated circuit;
- optionally thinning down the semiconductor wafer to a desired thickness from a backside of the semiconductor wafer;
- optionally subsequent polishing the backside of the semiconductor wafer and/or applying an interface layer on the backside of the semiconductor wafer;
- singulating the semiconductor wafer into at least one die comprising the at least one integrated circuit;
- providing an internal heat spreader substrate comprising a heat spreader material;
- optionally patterning a surface of the internal heat spreader substrate or an additional permanent bonding layer deposited on the surface of the internal heat spreader substrate;
- depositing a dielectric layer with at least one cavity on a surface of the internal heat spreader substrate, wherein the at least one die fits into the at least one cavity of the dielectric layer;
- placing the at least one die in the at least one cavity;
- bonding the at least one die to the internal heat spreader substrate.

12. Method according to claim 11 further comprising depositing an interface layer having a thickness in $\mu$m- or sub-$\mu$m range preferably in the range of 20 nm to 30 $\mu$m at a bottom of the at least one cavity before placing the at least one die in the at least one cavity or on the thinned semiconductor wafer.

13. Method according to any of claims 11 or 12 wherein depositing the dielectric layer with at least one cavity comprises

- depositing a dielectric layer on the surface of the internal heat spreader substrate and subsequent patterning the dielectric layer or
- placing a dielectric wafer with at least one fully prepared cavity on the surface of the internal heat spreader substrate or
- placing a dielectric wafer with at least one blind cavity on the surface of the internal heat spreader substrate and thinning down the wafer to fully realize the at least one cavity.

14. Method according to any of claims 11 to 13 further comprising the steps of applying a redistribution layer on a top the fan-out wafer-level package electrically connecting the at least one integrated circuit and applying interconnections electrically connecting the redistribution layer.

15. Method according to any of claims 11 to 14 further comprising the step of singulating at least one individual fan-out wafer-level package.

600    500    100

1000a

Fig. 1A

$R_{IC}$    $R_{TIM}$    $R_{Heatsink}$

P    $\theta_{amb}$

Fig. 1B

600

500

200

210

110

300

400

100

1000

Fig. 2A

$R_{IC}$  $R_{Interface}$  $R_{Interposer}$  $R_{TIM}$  $R_{Heatsink}$

P

$\theta_{amb}$

Fig. 2B

Fig. 3A

Fig. 3B

Fig. 3C

S2a

102a

101a
103a

104a

S3a

102a

101a
103a

104a

S4a

105a

102a
101a
103a

104a

S5a

100a

Fig. 4

Fig. 5

Fig. 6

Fig. 7

Fig. 8

Fig. 9

Fig. 10

Fig. 11

Europäisches
Patentamt

European
Patent Office

Office européen
des brevets

# EUROPEAN SEARCH REPORT

Application Number

EP 21 21 4621

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/306067 A1 (TSAO PEI-HAW [TW] ET AL) 6 December 2012 (2012-12-06) * paragraphs [0012] – [0028]; figures 1-10 * | 1-3 | INV. H01L23/36 H01L21/60 H01L23/66 |
| X | EP 3 869 554 A1 (HUAWEI TECH CO LTD [CN]) 25 August 2021 (2021-08-25) * paragraphs [0011], [0017] – [0021], [0030], [0032]; claim 7; figure 4 * | 1-4 | ADD. H01L25/10 |
| X | US 2019/237382 A1 (KIM JAE CHOON [KR] ET AL) 1 August 2019 (2019-08-01) * paragraphs [0043], [0051] – [0053]; figures 4,5,8 * | 1-4 | |
| X | US 2014/264800 A1 (GOWDA ARUN VIRUPAKSHA [US] ET AL) 18 September 2014 (2014-09-18) * paragraphs [0035], [0061] – [0062], [0064] – [0068]; figures 19,21 * | 1-4 | |
| X | US 2005/212129 A1 (HUANG CHIEN-PING [TW] ET AL) 29 September 2005 (2005-09-29) * paragraphs [0028] – [0039], [0050]; figures 2a-2f * | 1-3, 11-15 | TECHNICAL FIELDS SEARCHED (IPC) H01L |
| X | US 2002/070443 A1 (MU XIAO-CHUN [US] ET AL) 13 June 2002 (2002-06-13) * paragraphs [0024] – [0026], [0028] – [0030], [0039]; figures 8-19,22-24 * | 1-4, 11-15 | |

The present search report has been drawn up for all claims

| Place of search | Date of completion of the search | Examiner |
|---|---|---|
| Munich | 23 August 2022 | Manook, Rhoda |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

**1-4, 11-15**

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the
requirements of unity of invention and relates to several inventions or groups of inventions, namely:

1. claims: 1-3

   (re. claims 2 and 3):
   Fan-out wafer-level package comprising
   - at least one integrated circuit,
   - an internal heat spreader thermally connected to the
   integrated circuit
    either directly or via an interface layer having a
   thickness inIJ m- or sub-??? range preferably in the range
   of 20 nm to 1 mm,
    wherein the internal heat spreader is embedded in the
   fan-out wafer-level package.
   wherein the internal head spreader has a thermal resistivity
   in the range of mK * mm2 /W.
   wherein the internal heat spreader comprises Si or a metal.
   ---

2. claim: 4

   (re. claim 4):
   Fan-out wafer-level package comprising- at least one
   integrated circuit,- an internal heat spreader thermally
   connected to the integrated circuit either directly or via
   an interface layer having a thickness inIJ m- or sub-???
   range preferably in the range of 20 nm to 1 mm, wherein the
   internal heat spreader is embedded in the fan-out
   wafer-level package
   and at least two integrated circuits, wherein the internal
   heat spreader is thermally connected to the at least two
   integrated circuits.
   ---

3. claims: 5, 6

   (re. claim 5):
   Fan-out wafer-level package comprising- at least one
   integrated circuit,- an internal heat spreader thermally
   connected to the integrated circuit either directly or via
   an interface layer having a thickness inIJ m- or sub-???
   range preferably in the range of 20 nm to 1 mm, wherein the
   internal heat spreader is embedded in the fan-out
   wafer-level package and
   the internal heat spreader comprises additional heat sink
   structures.
   ---

4. claims: 7, 8

   (re. claim 7):
   Fan-out wafer-level package comprising- at least one
   integrated circuit,- an internal heat spreader thermally

Europäisches
Patentamt

European
Patent Office

Office européen
des brevets

**LACK OF UNITY OF INVENTION**
**SHEET B**

Application Number

EP 21 21 4621

The Search Division considers that the present European patent application does not comply with the requirements of unity of invention and relates to several inventions or groups of inventions, namely:

connected to the integrated circuit either directly or via an interface layer having a thickness inIJ m- or sub-??? range preferably in the range of 20 nm to 1 mm, wherein the internal heat spreader is embedded in the fan-out wafer-level package and
comprising an additional redistribution layer on a backside of the fan-out wafer-level package and at least one trough-substrate via electrically connecting the additional redistribution layer to a front of the fan-out wafer-level package, preferably to the at least one integrated circuit.

---

5. claims: 9, 10

(re. claim 9):
Fan-out wafer-level package comprising- at least one integrated circuit,- an internal heat spreader thermally connected to the integrated circuit either directly or via an interface layer having a thickness in  ?m- or sub-?m range preferably in the range of 20 nm to 1 mm, wherein the internal heat spreader is embedded in the fan-out wafer-level package and
at least one additional functional element either on top or on bottom of the fan-out wafer level package.

---

6. claims: 11-15(partially)

(re. partial claim 11 and 12):
Method for fabricating a fan-out wafer-level package comprising the steps:
- providing a semiconductor wafer with at least one integrated circuit;
- singulating the semiconductor wafer into at least one die comprising the at least one integrated circuit;
- providing an internal heat spreader substrate comprising a heat spreader material;
- depositing a dielectric layer with at least one cavity on a surface of the internal heat spreader substrate, wherein the at least one die fits into the at least one cavity of the dielectric layer;
- placing the at least one die in the at least one cavity;
- bonding the at least one die to the internal heat spreader substrate.
further comprising depositing an interface layer having a thickness in IJ m- or sub-¦jm range preferably in the range of 20 nm to 30 ¦jm at a bottom of the at least one cavity before placing the at least one die in the at least one cavity.

---

**LACK OF UNITY OF INVENTION**
**SHEET B**

Application Number

EP 21 21 4621

The Search Division considers that the present European patent application does not comply with the requirements of unity of invention and relates to several inventions or groups of inventions, namely:

7. claims: 11-15(partially)

(re. partial claim 11a, 11b)
The surplus technical features of claim 11a over the known common concept of partial claim 11 and surplus to all of the cited documents D1-D6 are:thinning down the semiconductor wafer to a desired thickness from a backside of the semiconductor wafer.
The surplus technical features of claim 11b over the known common concept of partial claim 11 and surplus to all of the cited documents D1-D6 are: subsequent polishing the backside of the semiconductor wafer and/or applying an interface layer on the backside of the semiconductor wafer;
---

8. claims: 11-15(partially)

(re. partial claim 11c)
The surplus technical features of claim 11c over the known common concept of partial claim 11 and surplus to all of the cited documents D1-D6 are: patterning a surface of the internal heat spreader substrate.
---

9. claims: 11, 13-15(all partially)

(partial claim 11 and 13):
The surplus technical features of claim 13 over the known common concept of partial claim 11 and surplus to all of the cited documents D1-D6 are: depositing the dielectric layer with at least one cavity comprises- depositing a dielectric layer on the surface of the internal heat spreader substrate and subsequent patterning the dielectric layer or- placing a dielectric wafer with at least one blind cavity on the surface of the internal heat spreader substrate and thinning down the wafer to fully realize the at least one cavity.
---

page 3 of 3

25

## ANNEX TO THE EUROPEAN SEARCH REPORT
## ON EUROPEAN PATENT APPLICATION NO.

EP 21 21 4621

This annex lists the patent family members relating to the patent documents cited in the above-mentioned European search report.
The members are as contained in the European Patent Office EDP file on
The European Patent Office is in no way liable for these particulars which are merely given for the purpose of information.

23-08-2022

| Patent document cited in search report | | Publication date | Patent family member(s) | | Publication date |
|---|---|---|---|---|---|
| US 2012306067 | A1 | 06-12-2012 | CN | 102810520 A | 05-12-2012 |
| | | | US | 2012306067 A1 | 06-12-2012 |
| EP 3869554 | A1 | 25-08-2021 | CN | 112956019 A | 11-06-2021 |
| | | | EP | 3869554 A1 | 25-08-2021 |
| | | | WO | 2020093391 A1 | 14-05-2020 |
| US 2019237382 | A1 | 01-08-2019 | CN | 110098162 A | 06-08-2019 |
| | | | KR | 20190091751 A | 07-08-2019 |
| | | | US | 2019237382 A1 | 01-08-2019 |
| US 2014264800 | A1 | 18-09-2014 | CN | 104051376 A | 17-09-2014 |
| | | | EP | 2779231 A2 | 17-09-2014 |
| | | | JP | 6401468 B2 | 10-10-2018 |
| | | | JP | 2014179612 A | 25-09-2014 |
| | | | JP | 2018152591 A | 27-09-2018 |
| | | | KR | 20140113451 A | 24-09-2014 |
| | | | TW | 201448137 A | 16-12-2014 |
| | | | TW | 201804579 A | 01-02-2018 |
| | | | US | 2014264800 A1 | 18-09-2014 |
| | | | US | 2017077014 A1 | 16-03-2017 |
| US 2005212129 | A1 | 29-09-2005 | TW | I245350 B | 11-12-2005 |
| | | | US | 2005212129 A1 | 29-09-2005 |
| US 2002070443 | A1 | 13-06-2002 | AU | 3274702 A | 18-06-2002 |
| | | | CN | 1555573 A | 15-12-2004 |
| | | | EP | 1354354 A2 | 22-10-2003 |
| | | | JP | 2005506678 A | 03-03-2005 |
| | | | KR | 20040014432 A | 14-02-2004 |
| | | | US | 2002070443 A1 | 13-06-2002 |
| | | | WO | 0247162 A2 | 13-06-2002 |

EPO FORM P0459

For more details about this annex : see Official Journal of the European Patent Office, No. 12/82